# EUROPEAN PATENT APPLICATION

(11) **EP 4 478 407 A2**
(43) Date of publication of application: **18.12.2024**
(21) Application number: 24180732.0
(22) Date of filing: 07.06.2024
(51) Int. Cl.: H01L 23/528, H01L 21/8234, H01L 23/535

(54) **INTEGRATED CIRCUIT DEVICES INCLUDING A BACKSIDE POWER DISTRIBUTION NETWORK STRUCTURE AND METHODS OF FORMING THE SAME**

(30) Priority: 13.06.2023 US 202363507763 P; 17.10.2023 US 202318488412
(71) Applicant: Samsung Electronics Co., Ltd, Suwon-si, Gyeonggi-do 16677 (KR)
(72) Inventor: LEE, Jongjin, San Jose, CA, 95134 (US); SEO, Kang-ill, San Jose, CA, 95134 (US); PARK, Panjae, San Jose, CA, 95134 (US); KIM, Tae Sun, San Jose, CA, 95134 (US); HONG, Wonhyuk, San Jose, CA, 95134 (US)
(74) Representative: Kuhnen & Wacker Patent- und Rechtsanwaltsbüro PartG mbB

(57) **Abstract**

Integrated circuit devices 100 and methods of forming the same are provided. The integrated circuit devices 100 may include a transistor including first and second source/drain regions 102a, 102b spaced apart from each other in a horizontal direction X, a backside power distribution network structure, BSPDNS, a substrate between the first and second source/drain regions 102a, 102b and the BSPDNS, a backside contact that is in the substrate and is overlapped by the first source/drain region 102a, a placeholder that is in the substrate and is overlapped by the second source/drain region 102b, and a cavity in the substrate between the backside contact and the placeholder.

## Description

### BACKGROUND

The present disclosure generally relates to the field of integrated circuit devices and, more particularly, to integrated circuit devices including a backside power distribution network structure (BSPDNS).

Various structures of an integrated circuit device and methods of forming the same have been proposed to increase the integration density of the integrated circuit device. Specifically, an integrated circuit device including elements formed in a substrate or on a backside of the substrate has been proposed to simplify the middle-of-line (MOL) portion and/or the back-end-of-line (BEOL) portion of device fabrication.

### SUMMARY

An integrated circuit device according to some embodiments may include a transistor including first and second source/drain regions spaced apart from each other in a horizontal direction, a backside power distribution network structure (BSPDNS), a substrate between the first and second source/drain regions and the BSPDNS, a backside contact that is in the substrate and is overlapped by the first source/drain region, a placeholder that is in the substrate and is overlapped by the second source/drain region, and a cavity in the substrate between the backside contact and the placeholder.

An integrated circuit device according to some embodiments may include a transistor including a channel region and a source/drain region contacting a side surface of the channel region, a backside power distribution network structure (BSPDNS), a substrate between the source/drain region and the BSPDNS, a backside contact that is in the substrate and is between the source/drain region and the BSPDNS, and a cavity that is in the substrate and is overlapped by the channel region.

A method of forming an integrated circuit device according to some embodiments may include forming first and second source/drain regions on a preliminary substrate and forming first and second preliminary placeholders in the preliminary substrate, wherein the first and second source/drain regions overlap the first and second preliminary placeholders, respectively, replacing the preliminary substrate with a substrate, wherein the substrate comprises a cavity between the first and second preliminary placeholders, forming an opening in the substrate by removing the first preliminary placeholder, forming a backside contact in the opening, and forming a backside power distribution network structure (BSPDNS) on the backside contact, wherein the backside contact is electrically connected to the BSPDNS and the first source/drain region.

### BRIEF DESCRIPTION OF THE DRAWINGS

FIG. 1 is a layout view of an integrated circuit device according to some embodiments.
FIGS. 2A, 2B, and 2C are cross-sectional views of an integrated circuit device respectively taken along the lines X-X', Y1-Y1', and Y2-Y2' in FIG. 1 according to some embodiments.
FIG. 3 is a flow chart of methods of forming an integrated circuit device according to some embodiments.
FIGS. 4 through 9, 10A, 10B, 10C, 11A, 11B, and 11C are cross-sectional views illustrating methods of forming an integrated circuit device according to some embodiments.
FIG. 12 is a layout view of an integrated circuit device according to some embodiments.
FIGS. 13A, 13B, and 13C are cross-sectional views of an integrated circuit device respectively taken along the lines X-X', Y1-Y1', and Y2-Y2' in FIG. 12 according to some embodiments.

### DETAILED DESCRIPTION

An integrated circuit device may include backside contact(s) and placeholder(s) (also referred to as dummy placeholder(s) or dummy contact(s)). Each of the backside contact(s) and the placeholder(s) may include at least a portion provided in a substrate. The backside contact(s) and the placeholder(s) may be formed by forming preliminary placeholder(s) and then replacing a first group of preliminary placeholder(s) with the backside contact(s), respectively. In some embodiments, a second group of those preliminary placeholder(s) may not be replaced with backside contact(s) and remain in the integrated circuit device after a BSPDNS is formed. In some embodiments, the backside contact(s) and the placeholder(s) may include conductive material(s) and/or semiconductor material(s), and the parasitic capacitance between two of the backside contact(s) and the placeholder(s), which are adj acent to each other, exists. That parasitic capacitance may cause resistive-capacitive (RC) delay, thereby deteriorating the performance of the integrated circuit device. That parasitic capacitance may be reduced or eliminated by two approaches: (1) forming preliminary placeholder(s) (i.e., the first group of preliminary placeholder(s)) only at the locations where the backside contact(s) need to be formed; or (2) removing some of already formed preliminary placeholder(s) (i.e., the second group of preliminary placeholder(s)). Both of those two approaches, however, involves additional processes (e.g., a lithograph process and/or an etching process).

According to some embodiments, a cavity may be formed in the substrate between two adjacent ones of the placeholder(s) and the backside contact(s), thereby reducing the parasitic capacitance therebetween without the additional processes described above. Accordingly, resistive-capacitive (RC) delay may be reduced, and the performance of the integrated circuit device may be improved.

Example embodiments will be described in greater detail with reference to the attached figures.

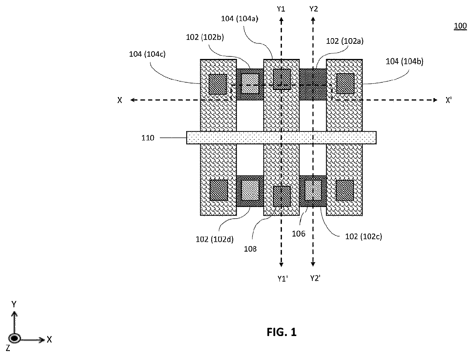

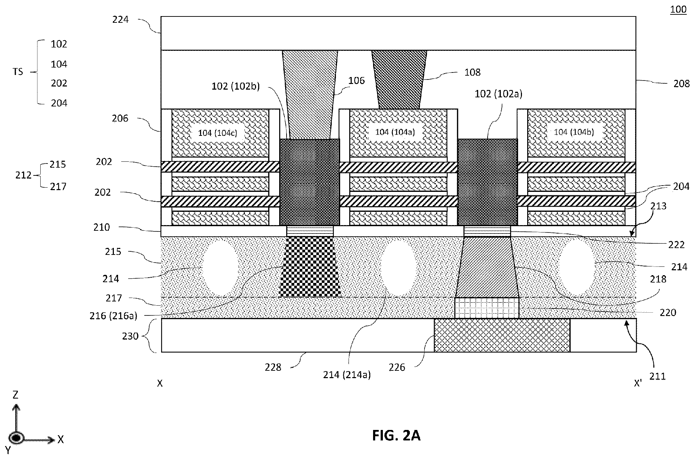

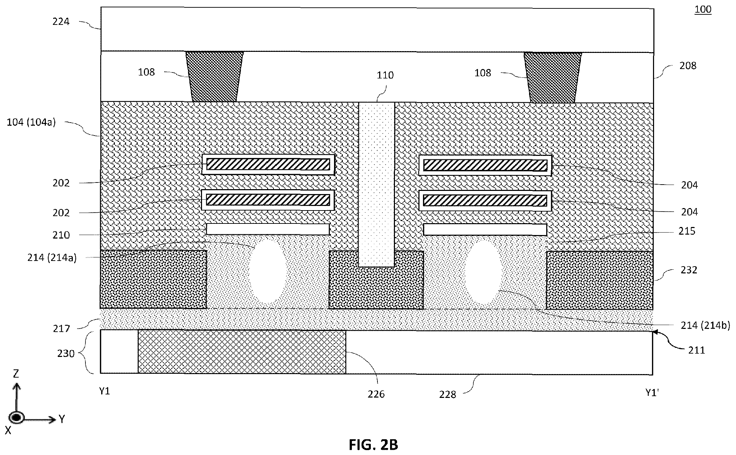

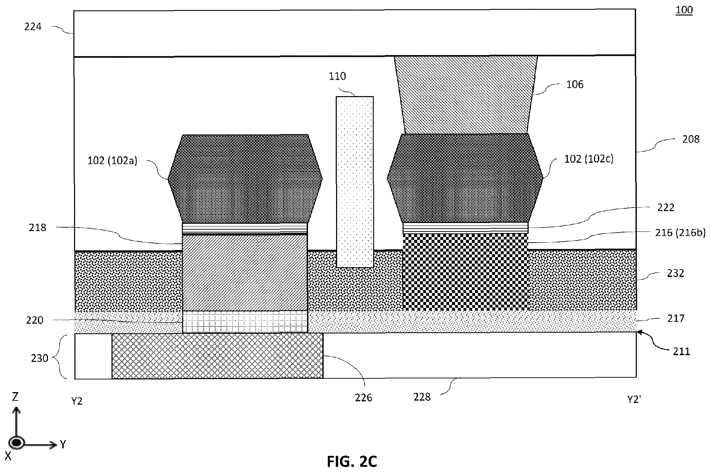

FIG. 1 is a layout view of an integrated circuit device 100 according to some embodiments. FIGS. 2A, 2B, and 2C are cross-sectional views of the integrated circuit device 100 respectively taken along the lines X-X', Y1-Y1', and Y2-Y2' in FIG. 1 according to some embodiments. Referring to FIGS. 1, 2A, 2B, and 2C, the integrated circuit device 100 may include a substrate 212 (also referred to as a backside insulating layer) and transistor structures TS (also referred to as transistors) on the substrate 212. A lower surface 211 of the substrate 212 may extend in a first direction X (also referred to as a first horizontal direction) and a second direction Y (also referred to as a second horizontal direction). The first direction X and the second direction Y may be parallel to the lower surface 211 of the substrate 212. In some embodiments, the first direction X may be perpendicular to the second direction Y.

In some embodiments, the substrate 212 may include or may be insulating material(s), for example, silicon oxide, silicon oxynitride, silicon nitride, silicon carbonitride, silicon boron nitride and/or a low-k material. The low-k material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric. In some other embodiments, the substrate 212 may include or may be semiconductor material(s), for example, Si, Ge, SiGe, GaP, GaAs, SiC, SiGeC and/or InP. For example, the substrate 212 may be insulating layer(s), a bulk substrate (e.g., a bulk silicon wafer) and/or a semiconductor on insulator (SOI) substrate. A thickness of the substrate 212 in a third direction Z (also referred to as a vertical direction) may be in a range of 50 nm to 100 nm. In some embodiments, the third direction Z may be perpendicular to the first direction X. The third direction Z may be perpendicular to the lower surface 211 of the substrate 212.

The substrate 212 may include portions separated from each other by a trench isolation layer 232. The trench isolation layer 232 may include an insulating material(s) (e.g., silicon oxide, silicon oxynitride, silicon nitride, silicon carbonitride, silicon boron nitride and/or a low-k material). The substrate 212 may include an upper portion 215 and a lower portion 217. The upper portion 215 of the substrate 212 may be between the transistor structures TS and the lower portion 217 of the substrate 212. The upper and lower portions 215 and 217 of the substrate 212 may include the same material(s), and thus an interface therebetween may not be readily apparent. For ease of illustration, a dashed line in FIGS. 2A and 2B indicates an interface between the upper and lower portions 215 and 217 of the substrate 212.

Each of the transistor structures TS may include a gate electrode 104 and a channel region 202. In some embodiments, each of the transistor structures TS may include multiple channel regions 202 stacked in the third direction Z, and the channel regions 202 may be spaced apart from each other in the third direction Z. Each of the transistor structures TS may also include a gate insulator 204. The channel region 202 may extend through the gate electrode 104 in the first direction X, and the gate insulator 204 may be provided between the gate electrode 104 and the channel region 202. The gate insulator 204 may contact the gate electrode 104 and the channel region 202 and may separate the gate electrode 104 from the channel region 202.

Each of the transistor structures TS may also include a pair of source/drain regions 102 (e.g., first and second source/drain regions 102a and 102b or third and fourth source/drain regions 102c and 102d) that may be spaced apart from each other in the first direction X. The gate electrode 104 (e.g., a first gate electrode 104a) may be provided between the pair of source/drain regions 102. The pair of source/drain regions 102 may contact opposing side surfaces of the channel region 202, respectively, as illustrated in FIG. 2A. The opposing side surfaces of the channel region 202 may be spaced apart from each other in the first direction X.

The channel region 202 may include semiconductor material(s) (e.g., Si, Ge, SiGe, GaP, GaAs, SiC, SiGeC and/or InP). In some embodiments, the channel region 202 may be a nanosheet that may have a thickness in a range from 1 nanometers (nm) to 100 nm in the third direction Z or may be a nanowire that may have a circular cross-section with a diameter in a range of from 1 nm to 100 nm. Although not illustrated, in some embodiments, the channel region 202 may be shaped like a fin. When the channel region 202 is a nanosheet or nanowire, the gate electrode 104 may surround the channel region 202 on four sides. When the channel region 202 has a fin shape, the gate electrode 104 may surround the channel region 202 on two, three, or four sides.

Each of the source/drain regions 102 (e.g., first to fourth source/drain regions 102a, 102b, 102c and 102d) may include a semiconductor layer (e.g., a silicon (Si) layer and/or a silicon germanium (SiGe) layer) and may additionally include dopants in the semiconductor layer. In some embodiments, each of the source/drain regions 102 may include a metallic layer that includes, for example, tungsten (W), aluminum (Al), copper (Cu), molybdenum (Mo), cobalt (Co) and/or ruthenium (Ru).

The gate insulator 204 may include a single layer or multiple layers (e.g., a silicon oxide layer and/or a high-k material layer). For example, the high-k material layer may include Al₂O₃, HfO₂, ZrO₂, HfZrO₄, TiO₂, Sc₂O₃, Y₂O₃, La₂O₃, Lu₂O₃, Nb₂O₅ and/or Ta₂O₅.

The integrated circuit device 100 may include multiple gate electrodes 104 (e.g., first, second and third gate electrodes 104a, 104b, and 104c) that extend in the second direction Y and are spaced apart from each other in the first direction X. As used herein, "an element A extends in a direction X" (or similar language) may mean that the element A extends longitudinally in the direction X. Each of the gate electrodes 104 along with a respective gate insulator 204 may constitute a gate structure. Each of the gate electrodes 104 may include a single layer or multiple layers. In some embodiments, each of the gate electrodes 104 may include a metallic layer that includes, for example, W, Al, Cu, Mo, Co, and/or Ru and may additionally include work function layer(s) (e.g., a TiN layer, a TaN layer, a TiAl layer, a TiC layer, a TiAlC layer, a TiAlN layer and/or a WN layer). In some embodiments, each of the gate electrodes 104 may include the same material(s). The work function layer(s) may be provided between the metallic layer and the gate insulator 204. In some embodiments, the work function layer(s) may separate the metallic layer from the gate insulator 204.

In some embodiments, the transistor structure TS may be a three-dimensional (3D) field effect transistor (FET) such as a multi-bridge channel FET (MBCFET). In some embodiments, the transistor structure TS may have a structure different from that illustrated. For example, the transistor structure TS may be a gate-all-around FET (GAAFET) including a single channel region or a fin-shaped FET (FinFET).

An insulating spacer 206 (also referred to as a gate spacer or an inner gate spacer) may be provided between the gate electrode 104 and the source/drain region 102 to separate the gate electrode 104 from the source/drain region 102. The insulating spacer 206 may include, for example, silicon oxide, silicon oxynitride, silicon nitride, silicon carbonitride, silicon boron nitride and/or a low-k material. The channel region 202 may extend through the insulating spacer 206 to contact the source/drain regions 102 (e.g., the first and second source/drain regions 102a and 102b and/or the third and fourth source/drain regions 102c and 102d) on opposing sides of the gate electrode 104 (e.g., the first gate electrode 104a) in the first direction X.

A first interlayer 210 may be provided on an upper surface 213 of the substrate 212. In some embodiments, the first interlayer 210 may extend between the substrate 212 and the transistor structures TS and may contact the upper surface 213 of the substrate 212 and the transistor structures TS.

A second interlayer 208 may be provided on the first interlayer 210 and the substrate 212, and the transistor structures TS may be provided in the second interlayer 208. In particular, the source/drain regions 102, the gate electrodes 104, the channel regions 202, and the gate insulators 204 may be provided in the second interlayer 208. Although the second interlayer 208 is illustrated as a single layer, in some embodiments, the second interlayer 208 may include multiple layers. A lower surface of the second interlayer 208 may contact an upper surface of the trench isolation layer 232. For example, the first interlayer 210 and the second interlayer 208 may each include insulating material(s) (e.g., silicon oxide, silicon oxynitride, silicon nitride, silicon carbonitride, silicon boron nitride and/or a low-k material).

Source/drain contacts 106 (also referred to as frontside contacts) may be provided in the second interlayer 208 on the second, third, and fourth source/drain regions 102b, 102c, and 102d, respectively. The source/drain contacts 106 may respectively contact upper surfaces of the second, third, and fourth source/drain regions 102b, 102c, and 102d. The source/drain contacts 106 may electrically connect the second, third, and fourth source/drain regions 102b, 102c, and 102d to a conductive element (e.g., a conductive wire or a conductive via plug) of a back-end-of-line (BEOL) structure 224 that is formed through the BEOL portion of device fabrication. The source/drain contact 106 may include a metallic layer including, for example, W, Al, Cu, Mo, Co and/or Ru. As used herein, "a lower surface" of an element may refer to a surface facing the substrate 212, and "an upper surface" refers to a surface opposite the lower surface thereof. Further, as used herein, "a lower portion" refers to a portion that is closer than "an upper portion" to the substrate 212 and is thus between the upper portion thereof and the substrate 212.

Gate contacts 108 may be provided in the second interlayer 208 on the gate electrodes 104, respectively. The gate contacts 108 may respectively contact upper surfaces of the gate electrodes 104. The gate contacts 108 may electrically connect the gate electrodes 104 to a conductive element (e.g., a conductive wire or a conductive via plug) of the BEOL structure 224. The gate contact 108 may include a metallic layer including, for example, W, Al, Cu, Mo, Co and/or Ru.

In some embodiments, each of the gate electrodes 104 may include portions that are spaced apart from each other in the second direction Y, and a cut layer 110 may separate those portions of the gate electrodes 104 from each other. The cut layer 110 may extend in the first direction X to separate portions of each of the gate electrodes 104 from each other. For example, the first gate electrode 104a may include a first portion that is between the first and second source/drain regions 102a and 102b and a second portion that is between the third and fourth source/drain regions 102c and 102d, and the cut layer 110 may be between the first and second portions of the first gate electrode 104a. A portion of the cut layer 110 may be in the trench isolation layer 232. The cut layer 110 may include an insulating material(s) (e.g., silicon oxide, silicon oxynitride, silicon nitride, silicon carbonitride, silicon boron nitride and/or a low-k material). In some embodiments, the cut layer 110 may be omitted.

The BEOL structure 224 may include a BEOL insulating layer, conductive wires (e.g., metal wires) that are provided in the BEOL insulating layer and are stacked in the third direction Z, and conductive via plugs (e.g., metal via plugs), each of which may electrically connect two conductive wires that are spaced apart from each other in the third direction Z. The BEOL insulating layer may include, for example, silicon oxide, silicon oxynitride, silicon nitride, silicon carbonitride, silicon boron nitride and/or a low-k material.

The integrated circuit device 100 may further include a backside contact 218 that is electrically connected to the first source/drain region 102a. The backside contact 218 may include a portion that is in the substrate 212. In some embodiments, the backside contact 218 (e.g., an entirety of the backside contact 218) may be in the upper portion 215 of the substrate 212. In some embodiments, the backside contact 218 may extend in the substrate 212 in the third direction Z. The backside contact 218 may be overlapped in the third direction Z by the first source/drain region 102a. As used herein, "an element A overlapping an element B in a direction Z" (or similar language) means that there is at least one line that extends in the direction Z and intersects both the elements A and B. The backside contact 218 may include a metallic layer including, for example, W, Al, Cu, Mo, Co and/or Ru.

A conductive layer 222 may be provided between the backside contact 218 and the first source/drain region 102a. The conductive layer 222 may be provided in the first interlayer 210. For example, lower and upper surfaces of the conductive layer 222 may be coplanar with lower and upper surfaces of the first interlayer 210, respectively. In some embodiments, the conductive layer 222 may include a metal silicide layer (e.g., tungsten silicide, aluminum silicide or copper silicide) or a metallic nitride layer (e.g., titanium nitride, tantalum nitride or tungsten nitride). The conductive layer 222 may contact the lower surface of the source/drain region 102 and an upper surface of the backside contact 218. In some embodiments, the conductive layer 222 may not be provided, and the backside contact 218 may directly contact the lower surface of the first source/drain region 102a.

A conductive plug 220 may be provided between the backside contact 218 and a backside power distribution network structure (BSPDNS) 230, which will be described below. The conductive plug 220 may contact a lower surface of the backside contact 218 and an upper surface of the BSPDNS 230 (e.g., an upper surface of a backside power rail 226). The conductive plug 220 may be in the substrate 212 (e.g., in the lower portion 217 of the substrate 212). The conductive plug 220 may include a metallic layer including, for example, W, Al, Cu, Mo, Co and/or Ru. The conductive layer 222, the backside contact 218, and the conductive plug 220 may electrically connect the first source/drain region 102a to a conductive element (e.g., the backside power rail 226) of the BSPDNS 230. The backside contact 218 may be between the first source/drain region 102a and the BSPDNS 230 in the third direction Z. The backside contact 218 may be electrically connected to the first source/drain region 102a and the BSPDNS 230.

In some embodiments, the backside contact 218 and the conductive plug 220 may comprise the same material. For example, the backside contact 218 and the conductive plug 220 may have an integrated unitary structure and may be monolithic. "An integrated unitary structure" herein may mean a structure formed by the same process or the same series of processes without a structurally or visibly separated sub-part therein. The conductive layer 222, the backside contact 218, and the conductive plug 220 may be collectively referred to as a backside contact structure.

The BSPDNS 230 may be provided on a lower surface of the conductive plug 220 and a lower surface of the backside contact 218. The BSPDNS 230 may contact the lower surface of the conductive plug 220 and a lower surface of the substrate 212 (e.g., a lower surface of the lower portion 217 of the substrate 212). The BSPDNS 230 may include a backside insulator 228 and a backside power rail 226 provided in the backside insulator 228. The backside power rail 226 may contact the lower surface of the conductive plug 220 and may be electrically connected to the conductive plug 220. The substrate 212 may be between a pair of source/drain regions 102 (e.g., the first and second source/drain regions 102a and 102b) and the BSPDNS 230.

The backside power rail 226 may be electrically connected to a power source with a predetermined voltage (e.g., a drain voltage or a source voltage). For example, the BSPDNS 230 may include a power delivery network. The power delivery network may include a wiring network, which is used to deliver the power source (e.g., drain and/or source voltages) to the backside power rail 226. The first source/drain region 102a may be electrically connected to the power source through the conductive layer 222, the backside contact 218, the conductive plug 220, and the backside power rail 226. The backside contact 218 may be electrically connected to the backside power rail 226 and the first source/drain region 102a. The backside contact 218 may be between the backside power rail 226 and the first source/drain region 102a in the third direction Z. As used herein, the backside power rail 226 refers to a conductive element included in the BSPDNS 230. For example, the backside power rail 226 may be a power rail, a conductive via plug, or a conductive wire included in the BSPDNS 230. The backside power rail 226 may include a metallic layer including, for example, W, Al, Cu, Mo, Co and/or Ru.

In some embodiments, each of the source/drain contact 106 and the gate contact 108 may include a Co layer and/or a W layer, and each of the backside contact 218 and the backside power rail 226 may include a Cu layer. In some embodiments, a barrier layer may be provided on a surface of each of the source/drain contact 106, the gate contact 108, the backside contact 218, and the backside power rail 226. The barrier layer may include, for example, metal nitride layer(s) (e.g., a TiN layer and/or a TaN layer).

For ease of illustration, FIGS. 2A to 2C illustrate that the BSPDNS 230 includes the backside power rail 226 and the backside insulator 228, but it will be understood that the BSPDNS 230 may include one or more conductive layers (e.g., metal layers) stacked in the third direction Z that provide backside power delivery to the transistor structure TS. The conductive layers may be respectively included in insulating layers, and conductive via plugs (e.g., metal via plugs) may electrically connect the conductive layers to each other in the third direction Z. For example, although the backside insulator 228 is illustrated as a single layer, in some embodiments, the backside insulator 228 may include multiple layers stacked on the lower surface 211 of the substrate 212. The conductive layers may include one or more conductive wires (e.g., metal wires). In some embodiments, an intervening structure may be provided between the substrate 212 and the BSPDNS 230 and may separate the substrate 212 from the BSPDNS 230. The BSPDNS 230 may increase a power delivery efficiency in the integrated circuit device 100, reduce an area used for power delivery in the integrated circuit device 100, and/or improve a voltage drop (i.e., IR drop) in the integrated circuit device 100.

The integrated circuit device 100 may further include placeholders 216 in the substrate 212 (e.g., in the upper portion 215 of the substrate 212). The second, third, and fourth source/drain regions 102b, 102c, and 102d may respectively be on the placeholders 216. For example, respective ones of the source/drain regions 102 that are electrically connected to the source/drain contacts 106 may respectively be on the placeholders 216. The second, third, and fourth source/drain regions 102b, 102c, and 102d may respectively overlap the placeholders 216 in the third direction Z.

The conductive layer 222 may be in the first interlayer 210 between each of the placeholders 216 and a respective one of the second, third, and fourth source/drain regions 102b, 102c, and 102d. In some embodiments, the conductive layer 222 may be omitted, and the placeholders 216 may directly contact the second, third, and fourth source/drain regions 102b, 102c, and 102d, respectively.

Still referring to FIGS. 2A and 2C, the second source/drain region 102b may be on a first placeholder 216a, and the third source/drain region 102c may be on a second placeholder 216b. That is, the second source/drain region 102b may overlap the first placeholder 216a in the third direction Z, and the third source/drain region 102c may overlap the second placeholder 216b in the third direction Z. Although not illustrated, the fourth source/drain region 102d may also overlap one of the placeholders 216 in the third direction Z. The first placeholder 216a may be adjacent to the backside contact 218 in the first direction X. The trench isolation layer 232 may be on opposing side surfaces of the placeholders 216 in the second direction Y.

The substrate 212 (e.g., the lower portion 217 of the substrate 212) may be between the placeholders 216 and the BSPDNS 230 and may separate the placeholders 216 from the BSPDNS 230. A thickness of each of the placeholders 216 in the third direction Z may be equal to a thickness of the backside contact 218 in the third direction Z. For example, a thickness of the first placeholder 216a in the third direction Z may be equal to the thickness of the backside contact 218 in the third direction Z. Upper and lower surfaces of each of the placeholders 216 may respectively be coplanar with upper and lower surfaces of the backside contact 218. For example, upper and lower surfaces of the first placeholder 216a may respectively be coplanar with the upper and lower surfaces of the backside contact 218. The lower surface of the backside contact 218 and respective lower surfaces of the placeholders 216 may be spaced apart from an upper surface 213 of the substrate 212 in the third direction Z by an equal distance. For example, the lower surface of the backside contact 218 and a lower surface of the first placeholder 216a may be spaced apart from the upper surface 213 of the substrate 212 in the third direction Z by an equal distance.

The placeholder 216 may include a material different from the backside contact 218 and/or the substrate 212. The placeholder 216 may include, for example, a semiconductor material (e.g., Si or SiGe) and/or an insulating material (e.g., silicon oxide, silicon oxynitride, silicon nitride, silicon carbonitride, silicon boron nitride and/or a low-k material).

The integrated circuit device 100 may further include cavities 214 in the substrate 212 (e.g., in the upper portion 215 of the substrate 212). The cavities 214 may be arranged in the first direction X. Each of the cavities 214 may have a round shape that is symmetrical. For example, each of the cavities 214 may include opposing side surfaces curved outwardly (e.g., convex side surfaces). Each of the cavities 214 may be symmetrical with respect to a center line that passes through a center thereof in the first direction X and extends in the third direction Z, as illustrated in FIG. 2A. In some embodiments, each of the cavities 214 may also be symmetrical with respect to a center line that passes through a center thereof in the second direction Y and extends in the third direction Z, as illustrated in FIG. 2B.

The cavities 214 may respectively be between portions of the substrate 212 that are overlapped by the source/drain regions 102 in the third direction Z. In other words, the cavities 214 may respectively be overlapped by the channel regions 202 in the third direction Z. The cavities 214 may respectively be overlapped by the gate electrodes 104 in the third direction Z. Respective lower surfaces of the cavities 214 may be spaced apart from the lower surface 211 of the substrate 212 in the third direction Z by an equal distance. It will be understood that the cavity 214 may be, for example, any void or cavity, and may be a gap filled with air (e.g., an airgap), a gap filled with an inert gas or gases (e.g., an inert gas gap), a gap defining a vacuum (e.g., a vacuum gap), etc.

Referring to FIG. 2A, adjacent ones of the cavities 214 may be spaced apart from each other in the first direction X with the first placeholder 216a or the backside contact 218 therebetween. A first cavity 214a may be between the backside contact 218 and the first placeholder 216a in the first direction X. The first cavity 214a may be overlapped in the third direction Z by a channel region 202 (also referred to as a first channel region) that electrically connects the first and second source/drain regions 102a and 102b to each other. The first cavity 214a may be overlapped in the third direction Z by the first gate electrode 104a. A center of the first cavity 214a in the first direction X and a center of the first channel region 202 in the first direction X may be aligned in the third direction Z. The first cavity 214a may be spaced apart from the backside contact 218 and the first placeholder 216a in the first direction X by an equal distance. For example, the center of the first cavity 214a in the first direction X may be equidistant from a center of the backside contact 218 in the first direction X and a center of the first placeholder 216a in the first direction X. The first cavity 214a may be spaced apart from cavities 214 adjacent thereto in the first direction X by an equal distance. For example, the first gate electrode 104a, the first and second source/drain regions 102a and 102b, the first channel region 202, and a gate insulator 204 separating the first channel region 202 from the first gate electrode 104a may constitute a first transistor structure TS.

Referring to FIGS. 1 and 2B, the cavities 214 may also be spaced apart from each other in the second direction Y with the trench isolation layer 232 therebetween. For example, the first cavity 214a may be spaced apart from a second cavity 214b in the second direction Y with the trench isolation layer 232 therebetween. The cut layer 110 may also be between the first cavity 214a and the second cavity 214b in the second direction Y. A center of the first cavity 214a in the second direction Y may be aligned in the third direction Z with a center of the first channel region 202 in the second direction Y. The second cavity 214b may be overlapped by a channel region 202 (also referred to as a second channel region) that electrically connects the third and fourth source/drain regions 102c and 102d to each other. For example, the first gate electrode 104a, the third and fourth source/drain regions 102c and 102d, the second channel region 202, and a gate insulator 204 separating the second channel region 202 from the first gate electrode 104a may constitute a second transistor structure TS. The second transistor structure TS may be spaced apart from the first transistor structure TS in the second direction Y. The cut layer 110 may be between the first transistor structure TS and the second transistor structure TS.

Parasitic capacitance may exist between the backside contact 218 and the first placeholder 216a due to their proximity to each other, which may decrease the performance of the integrated circuit device 100. In some embodiments, the substrate 212 may include an insulating material and the first placeholder 216a may include a semiconductor material, which may further increase the parasitic capacitance between the backside contact 218 and the first placeholder 216a. For example, when conductive or semi-conductive electrical components are in proximity to each other and have different electric potentials, a parasitic capacitance may exist between the electrical components. The first cavity 214a in the substrate 212 between the backside contact 218 and the first placeholder 216a may reduce or eliminate the parasitic capacitance. A resistive-capacitive (RC) delay may thus be reduced, and the performance of the integrated circuit device 100 may be improved.

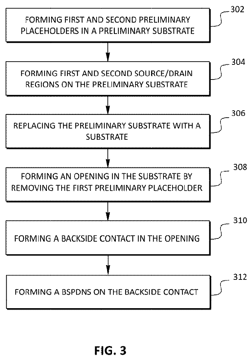

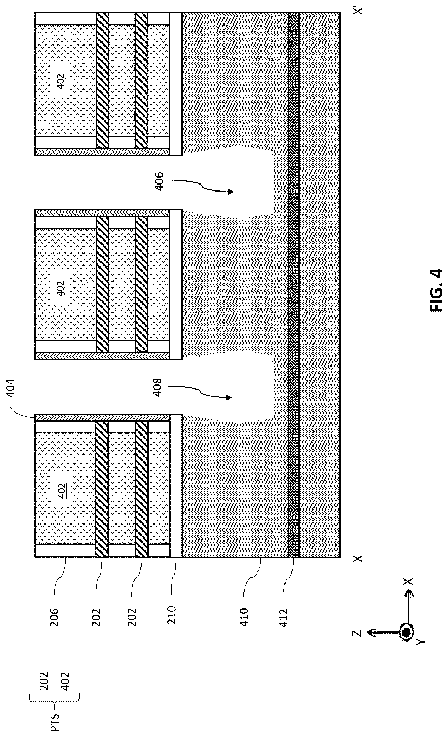

FIG. 3 is a flow chart of methods of forming an integrated circuit device (e.g., the integrated circuit device 100) according to some embodiments. FIGS. 4 through 9, 10A, 10B, 10C, 11A, 11B, and 11C are cross-sectional views illustrating methods of forming an integrated circuit device (e.g., the integrated circuit device 100) according to some embodiments. FIGS. 4 through 9, 10A, and 11A are cross-sectional views corresponding to the line X-X' of FIG. 1, FIGS. 10B and 11B are cross-sectional views corresponding to the line Y1-Y1' of FIG. 1, and FIGS. 10C and 11C are cross-sectional views corresponding to the line Y2-Y2' of FIG. 1.

Referring to FIG. 4, the first interlayer 210 may be formed on a preliminary substrate 410. Preliminary transistor structures PTS may be formed on the first interlayer 210 and the preliminary substrate 410. Each of the preliminary transistor structures PTS may include the channel region 202 and a sacrificial gate layer 402. In some embodiments, each of the preliminary transistor structures PTS may include multiple channel regions 202 and multiple portions of the sacrificial gate layer 402 that are alternately stacked with the channel regions 202, as illustrated in FIG. 4. The insulating spacer 206 may be formed on side surfaces of the sacrificial gate layer 402.

The preliminary substrate 410 may include one or more semiconductor materials, for example, Si, Ge, SiGe, GaP, GaAs, SiC, SiGeC and/or InP or may include insulating material, for example, silicon oxide, silicon oxynitride, silicon nitride, silicon carbonitride, silicon boron nitride and/or a low-k material. In some embodiments, the preliminary substrate 410 may be a bulk substrate (e.g., a bulk silicon substrate) or a semiconductor on insulator (SOI) substrate. For example, the preliminary substrate 410 may be a silicon wafer or may be an insulating layer. The preliminary substrate 410 may include an etch stop layer 412, and the etch stop layer 412 may include, for example, SiN, SiBCN, SiOCN, SiBN, SiCN, SiO and/or SiON.

The sacrificial gate layer 402 may include a material having an etch selectivity with respect to the channel region 202. The sacrificial gate layer 402 may include, for example, semiconductor material(s) (e.g., Si, Ge, SiGe, GaP, GaAs, SiC, SiGeC and/or InP). In some embodiments, the sacrificial gate layer 402 may include a SiGe layer.

In some embodiments, a gate liner 404 may be formed on the side surface of the insulating spacer 206. The gate liner 404 may include, for example, a layer including nitrogen (e.g., SiN, SiON, SiBCN, SiOCN, SiBN and/or SiCN) and may have a thickness, for example, in a range of from 1 nm to 5 nm (e.g., about 1 nm or 2 nm).

An upper surface of the preliminary substrate 410 may be etched to form first and second openings 406 and 408 in the preliminary substrate 410. The first and second openings 406 and 408 may be formed by a self-aligned etching process using the preliminary transistor structure PTS, the insulating spacer 206, and the gate liner 404 as an etching mask. For example, portions of the preliminary substrate 410, which are overlapped in the third direction Z by holes for source/drain regions to be formed later, may be etched, thereby forming the first and second openings 406 and 408 in the preliminary substrate 410. In some embodiments, the first and second openings 406 and 408 may be formed in the first interlayer 210 and the preliminary substrate 410. The first and second openings 406 and 408 may not extend completely through the preliminary substrate 410 in the third direction Z. For example, lower surfaces of the first and second openings 406 and 408 may be spaced apart from the etch stop layer 412 in the third direction Z with a portion of the preliminary substrate 410 therebetween.

A mask layer may be formed on the preliminary transistor structures PTS during the self-aligned etching process. The mask layer may include, for example, an inorganic material (e.g., SiN, SiBCN, SiOCN, SiBN, SiCN, SiON and/or a spin-on-glass material). The self-aligned etching process may include a dry etching process and/or a wet etching process.

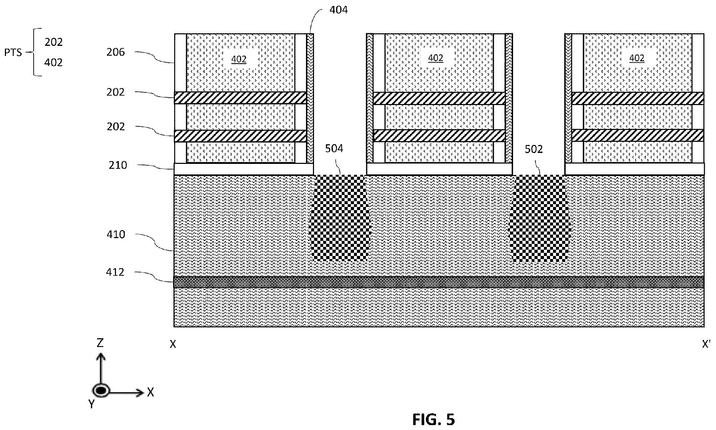

Referring to FIGS. 3 and 5, first and second preliminary placeholders 502 and 504 may be formed in the first and second openings 406 and 408 of the preliminary substrate 410, respectively, (Block 302). In some embodiments, the first and second preliminary placeholders 502 and 504 may be formed by performing an epitaxial growth process using the preliminary substrate 410 as a seed layer. Specifically, the first and second preliminary placeholders 502 and 504 may be grown from the preliminary substrate 410 through the epitaxial growth process. In some embodiments, the first and second preliminary placeholders 502 and 504 may be formed by performing a deposition process and then etching the first and second preliminary placeholders 502 and 504 to the upper surface of the preliminary substrate 410. In some embodiments, the first and second openings 406 and 408 may not be formed, and the first and second preliminary placeholders 502 and 504 may be formed by adding impurities into the preliminary substrate 410 using a doping process.

The first and second preliminary placeholders 502 and 504 may include, for example, a semiconductor material and/or an insulating material (e.g., SiGe, SiN or SiBCN). In some embodiments, the first and second preliminary placeholders 502 and 504 may include a SiGe layer including about 25 at% of germanium (e.g., from 15 at% to 25 at%). When a source/drain region to be formed later includes a SiGe layer, a germanium concentration of the source/drain region may be higher than the germanium concentration of the SiGe layer of the first and second preliminary placeholders 502 and 504. For example, the germanium concentration of the source/drain region may be about 55 at% (e.g., from 40 at% to 70 at%).The first and second preliminary placeholders 502 and 504 may be self-aligned with the preliminary transistor structure PTS. Upper surfaces of the first and second preliminary placeholders 502 and 504 may be coplanar with the upper surface of the preliminary substrate 410. A thickness of the first preliminary placeholder 502 in the third direction Z may be equal to a thickness of the second preliminary placeholder 504 in the third direction Z. Lower surfaces of the first and second preliminary placeholders 502 and 504 may be spaced apart from the upper surface of the preliminary substrate 410 in the third direction Z by an equal distance.

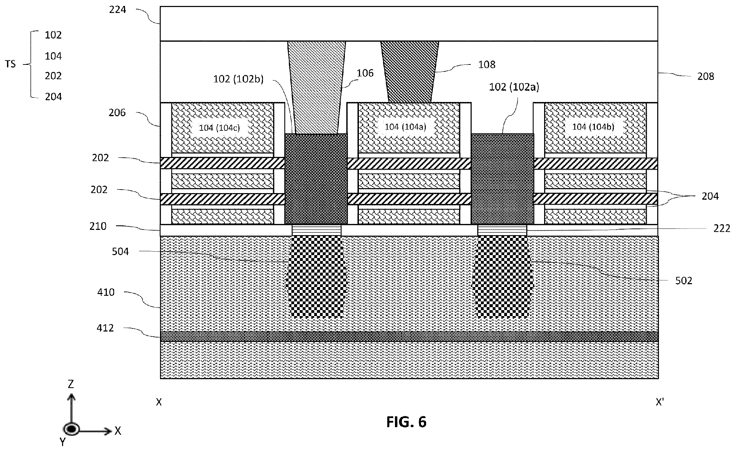

Referring to FIGS. 3 and 6, first and second source/drain regions 102a and 102b may be formed on the preliminary substrate 410 (Block 304). Although not specifically illustrated, the third and fourth source/drain regions 102c and 102d may also be formed on the preliminary substrate 410. The source/drain regions 102 may be formed by performing an epitaxial growth process using the channel regions 202 as a seed layer. Specifically, the source/drain regions 102 may be grown from opposing side surfaces of the channel regions 202 through the epitaxial growth process. The conductive layer 222 may be formed in the first interlayer 210 on the first and second preliminary placeholders 502 and 504 before forming the source/drain regions 102.

The gate liner 404 may be removed, and the sacrificial gate layers 402 may be removed and replaced with the gate electrodes 104 and the gate insulators 204. The transistor structures TS including a pair of the source/drain regions 102, the gate electrode 104, the channel region 202, and the gate insulator 204 may thus be formed.

The second interlayer 208, the source/drain contacts 106, and the gate contacts 108 may also be formed. The BEOL structure 224 may be formed on the second interlayer 208, the source/drain contacts 106, and the gate contacts 108.

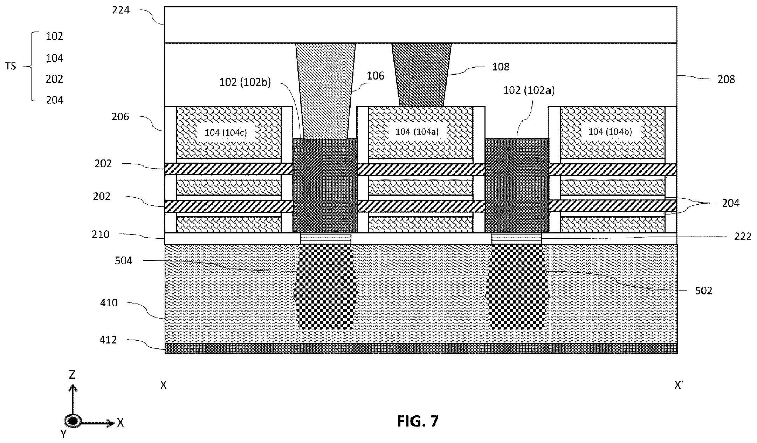

Referring to FIG. 7, a portion of the preliminary substrate 410 below the etch stop layer 412 may be removed. In some embodiments, the structure shown in FIG. 6 may be turned around (i.e., flipped), and the portion of the preliminary substrate 410 may be removed. For example, process(es) (e.g., a grinding process, a wet etching process, a dry etching process and/or a Chemical Mechanical Polishing (CMP) process) may be performed to remove the portion of the preliminary substrate 410 until the etch stop layer 412 is exposed. Although not illustrated, a carrier wafer may be bonded to the BEOL structure 224 before flipping the structure shown in FIG. 6 and removing the portion of the preliminary substrate 410.

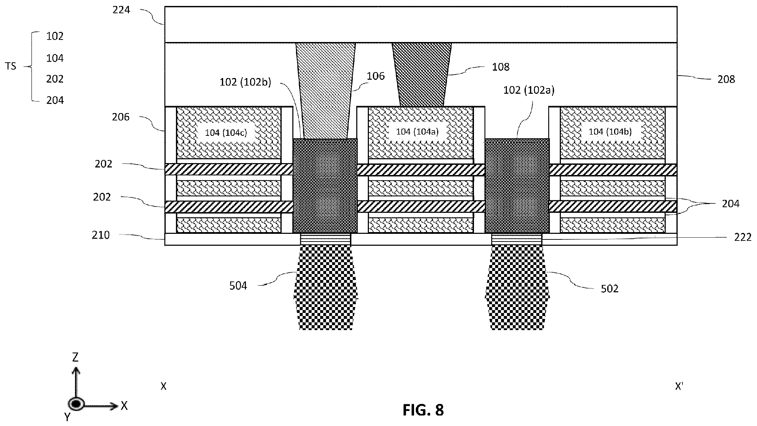

Referring to FIGS. 3, 8, and 9, the preliminary substrate 410 may be replaced with the substrate 212 (Block 306). Referring to FIG. 8, the preliminary substrate 410 and the etch stop layer 412 may be removed. For example, process(es) (e.g., a grinding process, a wet etching process, a dry etching process and/or a Chemical Mechanical Polishing (CMP) process) may be performed to remove the preliminary substrate 410 and the etch stop layer 412. The first interlayer 210 and the first and second preliminary placeholders 502 and 504 may be exposed by the removal of the preliminary substrate 410. The first and second preliminary placeholders 502 and 504 may include a different material than the preliminary substrate 410 and may thus have an etch selectivity with respect to the preliminary substrate 410. Accordingly, the preliminary substrate 410 and the etch stop layer 412 may be selectively removed without removing the first and second preliminary placeholders 502 and 504. In some embodiments, the first and second preliminary placeholders 502 and 504 may include SiGe, and the preliminary substrate 410 may include Si. However, the present disclosure is not limited thereto, and the first and second preliminary placeholders 502 and 504 and the preliminary substrate 410 may include other different materials having etch selectivity with respect to each other.

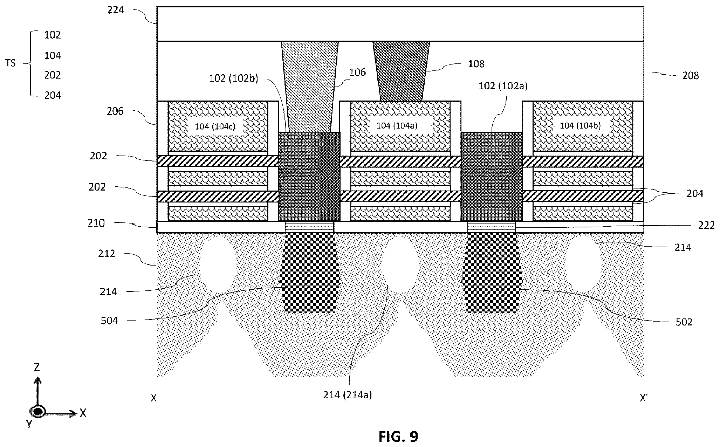

Referring to FIG. 9, the substrate 212 may be formed on the first and second preliminary placeholders 502 and 504 and the first interlayer 210. The substrate 212 may be formed by performing a nonconformal deposition process on the first and second preliminary placeholders 502 and 504. The nonconformal deposition process may include forming the substrate 212 to include the cavities 214 therein. For example, the nonconformal deposition process may include nonconformally depositing the substrate 212 such that the cavities 214 are formed therein. In other words, the cavities 214 may formed while performing the nonconformal deposition process of forming the substrate 212.

Adjacent ones of the cavities 214 may be spaced apart from each other in the first direction X with one of the first preliminary placeholder 502 or the second preliminary placeholder 504 therebetween. The first cavity 214a may be between the first and second preliminary placeholders 502 and 504. The first cavity 214a may be overlapped in the third direction Z by the first channel region 202 that electrically connects the first and second source/drain regions 102a and 102b to each other. The first cavity 214a may be overlapped in the third direction Z by the first gate electrode 104a. The first cavity 214a may be spaced apart from the first and second preliminary placeholders 502 and 504 in the first direction X by an equal distance. For example, a center of the first cavity 214a in the first direction X may be equidistant from respective centers of the first and second preliminary placeholders 502 and 504 in the first direction X.

The cavities 214 may be formed during the nonconformal deposition process to have a round shape that is symmetrical. For example, each of the cavities 214 may be symmetrical with respect to a center line that passes through a center thereof in the first direction X and extends in the third direction Z. Each of the cavities 214 may include opposing side surfaces curved outwardly (e.g., convex side surfaces).

The formation of the cavities 214 during the nonconformal deposition process may reduce costs and/or a number of fabrication steps for forming the cavities 214. A result of the nonconformal deposition process may be that the cavities 214 have a round shape that is symmetrical. The shape of the cavities 214 and/or the location of the cavities 214 (e.g., the spacing of the cavities 214 with respect to the first and second preliminary placeholders 502 and 504) may help further reduce or eliminate parasitic capacitance between a placeholder 216 (e.g., a first placeholder 216a) and a backside contact 218 to be described later.

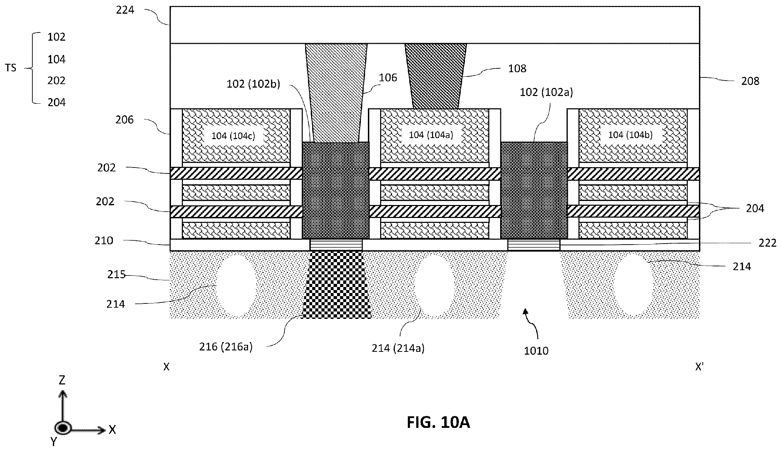

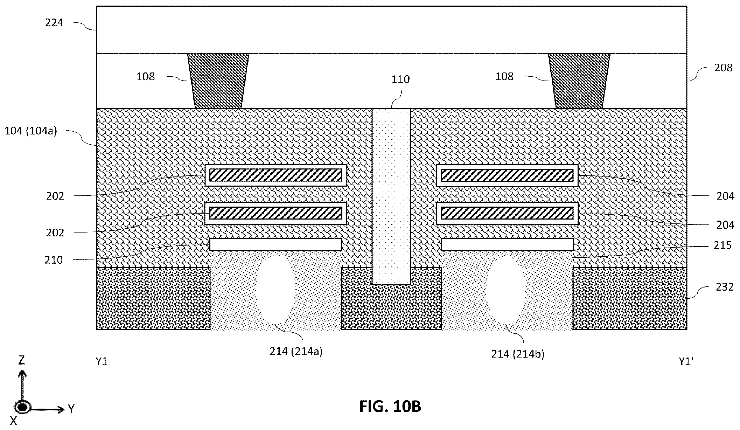

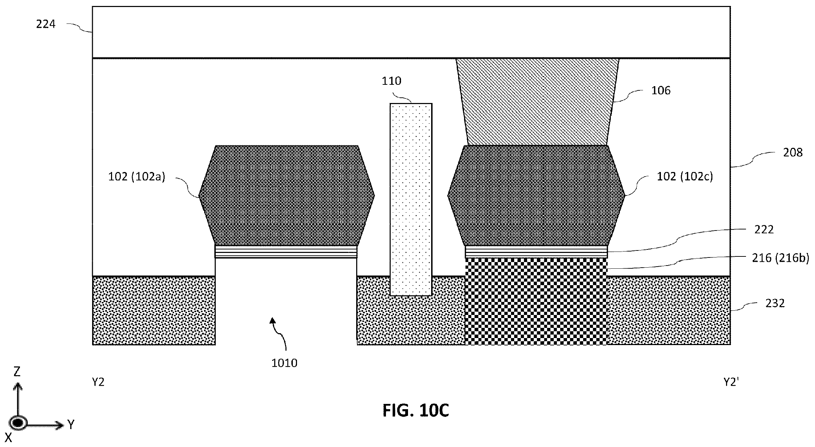

Referring to FIGS. 10A, 10B, and 10C, a lower portion of the substrate 212 and lower portions of the first and second preliminary placeholders 502 and 504 may be removed. As a result, the upper portion 215 of the substrate 212 and the first placeholder 216a may be formed. The lower portion of the substrate 212 and the lower portions of the first and second preliminary placeholders 502 and 504 may be removed by process(es) (e.g., a grinding process, a wet etching process, a dry etching process and/or a Chemical Mechanical Polishing (CMP) process). The process(s) may remove the lower portion of the substrate 212 and the lower portions of the first and second preliminary placeholders 502 and 504 until the trench isolation layer 232 is exposed. That is, the trench isolation layer 232 may serve as an etch stop for the process(s) for removing the lower portion of the substrate 212 and the lower portions of the first and second preliminary placeholders 502 and 504.

Referring to FIGS. 3, 10A, 10B, and 10C, an opening 1010 may be formed in the substrate 212 by removing the first preliminary placeholder 502 (Block 308). The first preliminary placeholder 502 may be removed after the lower portion thereof is removed. For example, an etching process (e.g., a wet etching process and/or a dry etching process) may be formed to remove the first preliminary placeholder 502. The substrate 212 and the trench isolation layer 232 may include a different material than the first preliminary placeholder 502 and may thus have an etch selectivity with respect to the first preliminary placeholder 502. Accordingly, the first preliminary placeholder 502 may be selectively removed without removing the substrate 212 and the trench isolation layer 232. In some embodiments, the substrate 212 and the trench isolation layer 232 may include an insulating material(s) (e.g., silicon oxide, silicon oxynitride, silicon nitride, silicon carbonitride, silicon boron nitride and/or a low-k material), and the first preliminary placeholder 502 may include SiGe. However, the present disclosure is not limited thereto, and the first preliminary placeholder 502 and the substrate 212 and the trench isolation layer 232 may include other different materials having etch selectivity with respect to each other.

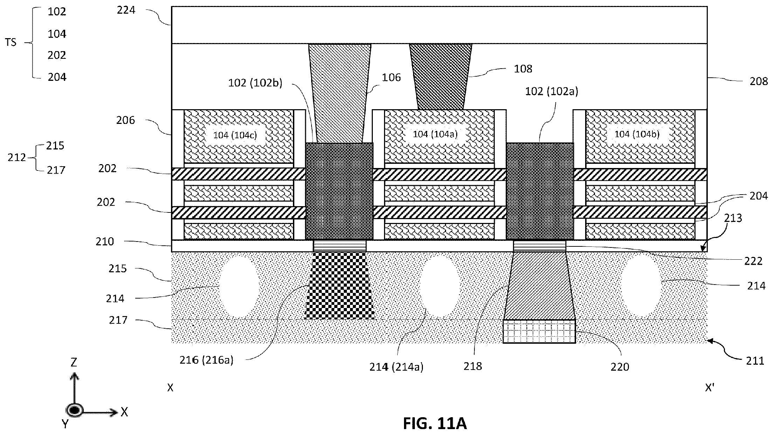

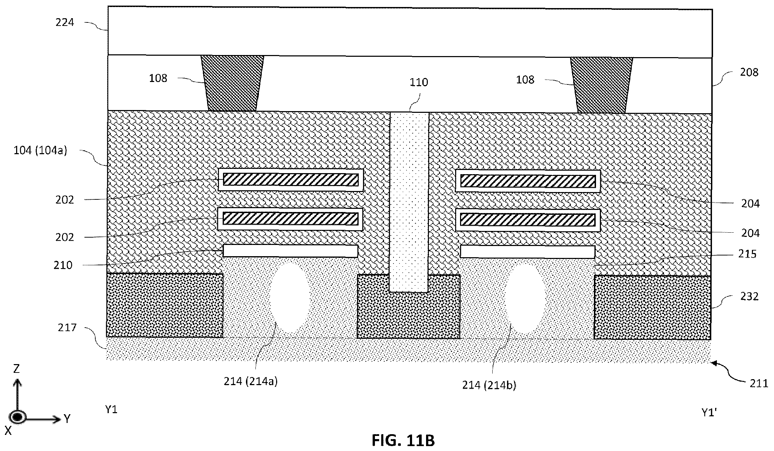

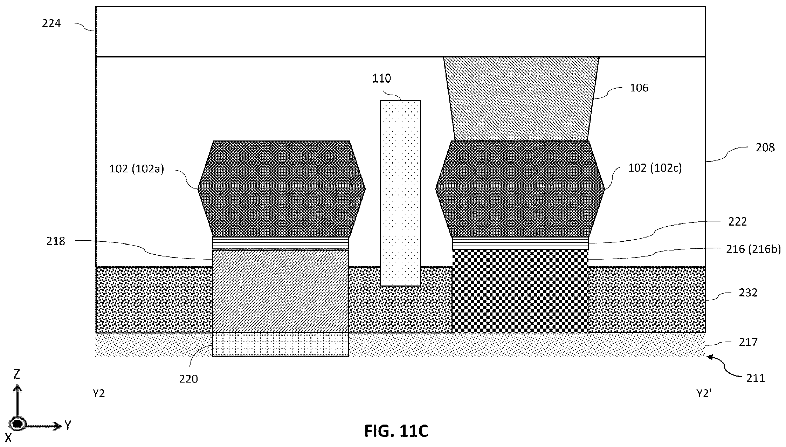

Referring to FIGS. 3, 11A, 11B, and 11C, the backside contact 218 may be formed in the opening 1010 (Block 310). The first cavity 214a may be between the backside contact 218 and the first placeholder 216a in the first direction X. A thickness of the backside contact 218 in the third direction Z may be equal to a thickness of the first placeholder 216a in the third direction Z. The conductive plug 220 may be formed on a lower surface of the backside contact 218 and may contact the lower surface of the backside contact 218. The lower portion 217 of the substrate 212 may be formed by a deposition process. The lower portion 217 of the substrate 212 may include the same material(s) as the upper portion 215 of the substrate 212. The lower portion 217 of the substrate 212 may be formed on a lower surface of the placeholders 216 (e.g., lower surfaces of the first and second placeholders 216a and 216b).

Referring back to FIGS. 2A, 2B, and 2C along with FIG. 3, the BSPDNS 230 may be formed on the backside contact 218 (Block 312). The backside contact 218 may be electrically connected to the BSPDNS 230 and the first source/drain region 102a. The backside contact 218 may be between the BSPDNS 230 and the first source/drain region 102a in the third direction Z. The BSPDNS 230 may contact a lower surface of the conductive plug 220 and may be electrically connected to the conductive plug 220. The BSPDNS 230 may include the backside insulator 228 and the backside power rail 226 provided in the backside insulator 228. The BSPDNS 230 may include a power delivery network, which is used to deliver a power source (e.g., drain and/or source voltages) to the backside power rail 226. The first source/drain region 102a may be electrically connected to the power source through the conductive layer 222, the backside contact 218, the conductive plug 220, and the backside power rail 226.

By forming the first cavity 214a in the substrate 212 between the backside contact 218 and the first placeholder 216a, parasitic capacitance between the backside contact 218 and the first placeholder 216a may be reduced or eliminated. A resistive-capacitive (RC) delay may thus be reduced, and the performance of the integrated circuit device 100 may be improved.

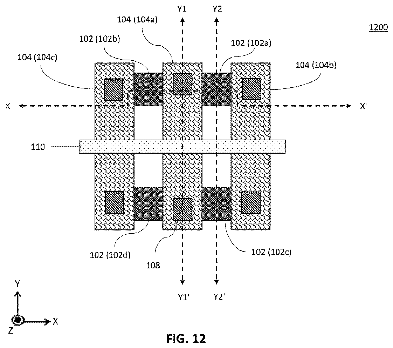

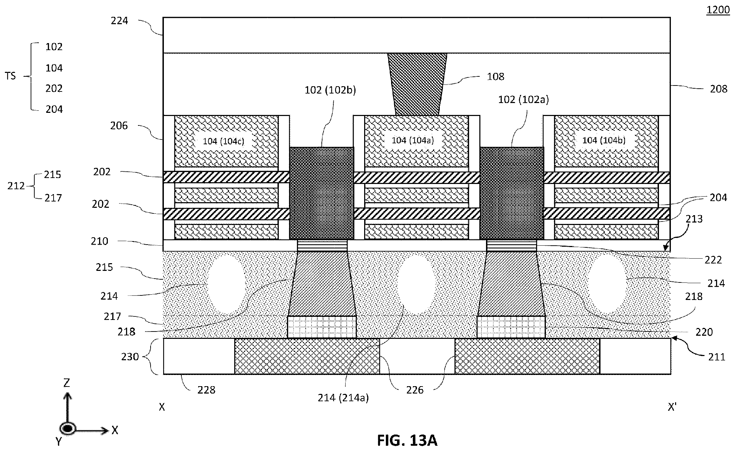

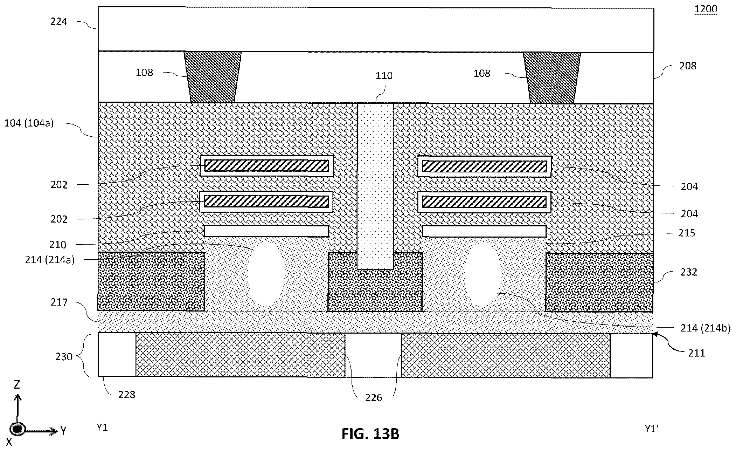

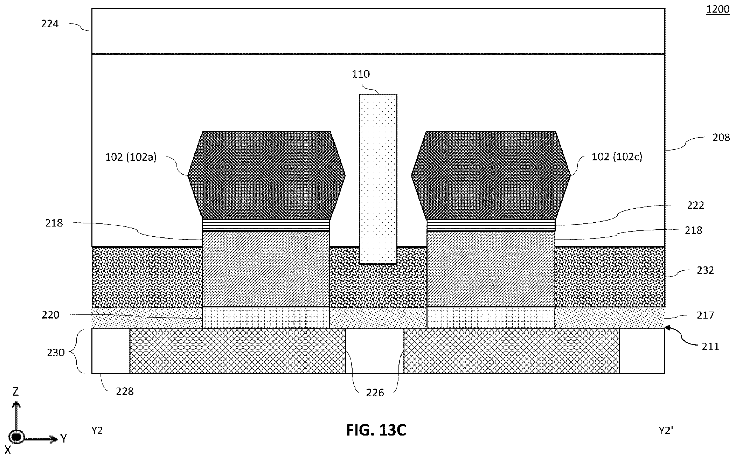

FIG. 12 is a layout view of an integrated circuit device 1200 according to some embodiments. FIGS. 13A, 13B, and 13C are cross-sectional views of an integrated circuit device 1200 respectively taken along the lines X-X', Y1-Y1', and Y2-Y2' in FIG. 12 according to some embodiments.

Referring to FIGS. 12, 13A, 13B, and 13C, the integrated circuit device 1200 may be similar to the integrated circuit device 100 described with reference to FIGS. 1, 2A, 2B, and 2C, and thus repeated description of like elements will be omitted. Unlike the integrated circuit device 100, the integrated circuit device 1200 may include backside contacts 218 that are electrically connected to the second, third, and fourth source/drain regions 102b, 102c, and 102d, respectively, in addition to the first source/drain region 102a. That is, the second, third, and fourth source/drain regions 102b, 102c, and 102d may be electrically connected to the backside contacts 218, respectively, and may not be electrically connected to the source/drain contacts 106. The integrated circuit device 1200 may not include the placeholders 216. The backside contacts 218 may be electrically connected to the first through fourth source/drain regions 102a, 102b, 102c, and 102d, respectively, and the BSPDNS 230 (e.g., the backside power rail 226). The backside insulator 228 may provide insulation between a power source (e.g., source and/or drain voltages) respectively delivered to a pair of the source/drain regions 102 (e.g., the first and second source/drain regions 102a and 102b) through the backside power rail 226.

The first cavity 214a may be between, in the first direction X, the backside contacts 218 that are electrically connected to the first and second source/drain regions 102a and 102b, respectively. A center of the first cavity 214a in the first direction X may be equidistant from a center of the backside contact 218 in the first direction X that is electrically connected to the first source/drain region 102a and a center of the backside contact 218 in the first direction X that is electrically connected to second source/drain region 102b. In other words, the first cavity 214a may be spaced apart equally in the first direction X from the backside contact 218 that is electrically connected to the first source/drain region 102a and the backside contact 218 that is electrically connected to the second source/drain region 102b.

It will be understood that the integrated circuit device 1200 can be formed by methods similar to those described with reference to FIGS. 4 through 9, 10A, 10B, 10C, 11A, 11B, and 11C with appropriate modification thereto. For example, the backside contact 218 of the integrated circuit device 1200 that is electrically connected to the second source/drain region 102b may be formed in substantially the same manner as the backside contact 218 described with reference to FIGS. 10A, 10B, 10C, 11A, 11B, and 11C. In particular, the backside contact 218 of the integrated circuit device 1200 that is electrically connected to the second source/drain region 102b may be formed by forming an opening in the substrate 212 by removing the second preliminary placeholder 504, and forming the backside contact 218 in the opening.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing. Although an element is illustrated as a single layer in the drawings, that element may include multiple layers.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. An integrated circuit device (100, 1200) comprising:
a transistor comprising first and second source/drain regions (102a, 102b) spaced apart from each other in a horizontal direction;
a backside power distribution network structure, BSPDNS (230);
a substrate (212) between the first and second source/drain regions (102a, 102b) and the BSPDNS (230);
a backside contact (218) that is in the substrate (212) and is overlapped by the first source/drain region (102a);
a placeholder (216, 216a) that is in the substrate (212) and is overlapped by the second source/drain region (102b); and
a cavity (214) in the substrate (212) between the backside contact (218) and the placeholder (216, 216a).

2. The integrated circuit device (100, 1200) of Claim 1, wherein:
the transistor further comprises a channel region (202) between the first and second source/drain regions (102a, 102b), preferably the channel region (202) overlaps the cavity (214), and preferably a center of the channel region (202) in the horizontal direction and a center of the cavity (214) in the horizontal direction are aligned in a vertical direction (Z).

3. The integrated circuit device (100, 1200) of Claim 1 or 2, wherein a center of the cavity (214) in the horizontal direction is equidistant from a center of the backside contact (218) in the horizontal direction and a center of the placeholder (216, 216a) in the horizontal direction, and/or
the cavity (214) is symmetrical with respect to a center line that passes through a center thereof in the horizontal direction and extends in a vertical direction (Z), and/or
the cavity (214) comprises opposing side surfaces curved outwardly, and/or
a thickness of the backside contact (218) in a vertical direction (Z) is equal to a thickness of the placeholder (216, 216a) in the vertical direction (Z).

4. The integrated circuit device (100, 1200) of any one of claims 1 to 3, wherein a lower surface of the backside contact (218) and a lower surface of the placeholder (216, 216a) are spaced apart from an upper surface (213) of the substrate (212) in a vertical direction (Z) by an equal distance.

5. The integrated circuit device (100, 1200) of Claim 1, further comprising:
an insulating layer (208) on the substrate (212), wherein the first and second source/drain regions (102a, 102b) are in the insulating layer (208); and
a source/drain contact (106) that is in the insulating layer (208) and is electrically connected to the second source/drain region (102b).

6. The integrated circuit device (100, 1200) of any one of claims 1 to 5, wherein:
the placeholder (216, 216a) comprises a material different from the backside contact (218), and/or
the backside contact (218) is electrically connected to a conductive element of the BSPDNS (230) and the first source/drain region (102a).

7. The integrated circuit device (100, 1200) of any one of claims 1 to 6, wherein the transistor is a first transistor comprising a first channel region (202), the horizontal direction is a first horizontal direction (X), and the cavity (214) is a first cavity (214a),
the first channel region (202) overlaps the first cavity (214a), and
the integrated circuit device (100, 1200) further comprises:
a second transistor comprising a second channel region (202), wherein the second transistor is spaced apart from the first transistor in a second horizontal direction (Y) perpendicular to the first horizontal direction (X); and
a second cavity (214b) that is in the substrate (212) and is spaced apart from the first cavity (214a), wherein the second channel region (202) overlaps the second cavity (214b).

8. An integrated circuit device (100, 1200) comprising:
a transistor comprising a channel region (202) and a source/drain region (102) contacting a side surface of the channel region (202);
a backside power distribution network structure, BSPDNS (230);
a substrate (212) between the source/drain region (102) and the BSPDNS (230);
a backside contact (218) that is in the substrate (212) and is between the source/drain region (102) and the BSPDNS (230); and
a cavity (214) that is in the substrate (212) and is overlapped by the channel region (202).

9. The integrated circuit device (100, 1200) of Claim 8, wherein the side surface of the channel region (202) is one of opposing side surfaces thereof, which are spaced apart from each other in a horizontal direction, and
the cavity (214) is symmetrical with respect to a center line that passes through a center thereof in the horizontal direction and extends in a vertical direction (Z).

10. The integrated circuit device (100, 1200) of Claim 8 or 9, wherein the side surface of the channel region (202) is a first side surface, the channel region (202) further comprises a second side surface opposite the first side surface, and the first and second side surfaces are spaced apart from each other in a horizontal direction,
the source/drain region (102) is a first source/drain region (102a) contacting the first side surface of the channel region (202), and the transistor further comprises a second source/drain region (102b) contacting the second side surface of the channel region (202),
the integrated circuit device (100, 1200) further comprises a placeholder (216, 216a) that is in the substrate (212) and is overlapped by the second source/drain region (102b), and
the cavity (214) is between the backside contact (218) and the placeholder (216, 216a).

11. The integrated circuit device (100, 1200) of any one of claims 8 to 10, wherein the side surface of the channel region (202) is a first side surface, the channel region (202) further comprises a second side surface opposite the first side surface, and the first and second side surfaces are spaced apart from each other in a horizontal direction,
the transistor further comprises a second source/drain region (102b) contacting the second side surface of the channel region (202),
the integrated circuit device (100, 1200) further comprises a placeholder (216, 216a) that is in the substrate (212) and is overlapped by the second source/drain region (102b), and
a center of the cavity (214) in the horizontal direction is equidistant from a center of the backside contact (218) in the horizontal direction and a center of the placeholder (216, 216a) in the horizontal direction.

12. A method of forming an integrated circuit device (100, 1200), the method comprising:
forming (304) first and second source/drain regions (102a, 102b) on a preliminary substrate (410) and forming first and second preliminary placeholders (502, 504) in the preliminary substrate (410), wherein the first and second source/drain regions (102a, 102b) overlap the first and second preliminary placeholders (502, 504), respectively;
replacing (306) the preliminary substrate (410) with a substrate (212), wherein the substrate (212) comprises a cavity (214) between the first and second preliminary placeholders (502, 504);
forming (308) an opening (406, 408, 1010) in the substrate (212) by removing the first preliminary placeholder (502);
forming (310) a backside contact (218) in the opening (406, 408, 1010); and
forming (312) a backside power distribution network structure, BSPDNS (230), on the backside contact (218), wherein the backside contact (218) is electrically connected to the BSPDNS (230) and the first source/drain region (102a).

13. The method of Claim 12, wherein replacing the preliminary substrate (410) with the substrate (212) comprises performing a nonconformal deposition process on the first and second preliminary placeholders (502, 504), and the cavity (214) is formed while performing the nonconformal deposition process.

14. The method of claim 12 or 13, wherein the first and second source/drain regions (102a, 102b) are spaced apart from each other in a horizontal direction, and
the cavity (214) is symmetrical with respect to a center line that passes through a center thereof in the horizontal direction and extends in a vertical direction (Z).

15. The method of any one of claims 12 to 14, wherein the first and second preliminary placeholders (502, 504) comprise a different material from the substrate (212).
